Europäisches Patentamt

European Patent Office

Office européen des brevets

(11) Publication number: **0 350 845 A2**

(19)

## EUROPEAN PATENT APPLICATION

(12)

(21) Application number: **89112606.2**

(51) Int. Cl.⁴: **H01L 21/22**

(22) Date of filing: **10.07.89**

The title of the invention has been amended (Guidelines for Examination in the EPO, A-III, 7.3).

(30) Priority: **12.07.88 JP 174107/88**
**12.07.88 JP 174111/88**
**18.07.88 JP 177228/88**
**28.07.88 JP 189211/88**
**28.07.88 JP 189212/88**
**21.04.89 JP 102280/89**

(43) Date of publication of application:
**17.01.90 Bulletin 90/03**

(84) Designated Contracting States:
**DE FR GB NL**

(71) Applicant: **SEIKO EPSON CORPORATION**
**4-1, Nishishinjuku 2-chome**
**Shinjuku-ku Tokyo-to(JP)**

(72) Inventor: **Kato, Juri**
**c/o Seiko Epson Corp. 3-5, Owa 3-chome**
**Suwa-shi Nagano-ken(JP)**

(74) Representative: **Blumbach Weser Bergen**
**Kramer Zwirner Hoffmann Patentanwälte**
**Radeckestrasse 43**
**D-8000 München 60(DE)**

(54) **Semiconductor device with doped regions and method for manufacturing it.**

(57) A semiconductor device includes at least one region which contains a first impurity comprising a group-V element and a second impurity comprising an element of high electronegativity or a halogen element such as F, Cl, O, Br, S, I or N in amorphous silicon, polycrystalline silicon, single crystal silicon, refractory metal such as Ti, Mo, W, Ta, Pt, Pd and Zr or a silicide of such refractory metal. The semiconductor device is manufactured by introducing the second impurity before, after or during the introduction of the first impurity, for example by ion implantation, into the amorphous, polycrystalline or single crystal silicon, refractory metal or silicide thereof and by subsequently carrying out an annealing in order to form an N-type impurity region. The semiconductor device is highly reliable with no changes of its characteristics and enables a miniaturization and a high integration degree.

FIG. 1

## SEMICONDUCTOR DEVICE AND METHOD FOR MANUFACTURING IT

The present invention relates to a semiconductor device and a method for manufacturing it. In particular, the invention relates to semiconductor devices including a bipolar transistor, a MISFET (Metal Insulator Semiconductor Field Effect Transistor) or an LSI (Large Scale Integrated Circuit Device) and to their manufacturing method. The present invention also relates to a semiconductor having a TFT (Thin Film Transistor) or a high resistance element.

In the technology for semiconductor integrated circuit devices (IC), particularly, BiCMOS (Bipolar Complementary Metal Oxide Semiconductor) integrated circuits, it has been a general procedure to form a P-type well region on an N-type semiconductor substrate and to form an N-channel type MISFET in the P-well region.

A technique for forming a bipolar transistor instead of a CMOS inverter, requiring a small driving power and constituting a power transistor in the final stage of an output section, etc. by utilizing a P-type well region is known from JP-A-57-130461.

That is, in the process of forming a CMOS integrated circuit, a P-type diffusion region as a base region is formed simultaneously with the production step for the P-type well region on an N-type semiconductor substrate. An $N^+$ region as an emitter region is formed simultaneously with the formation of source and drain regions on the P-type diffusion region. This process is used in order to form an NPN-type bipolar transistor on a BiCMOS integrated circuit without altering the process for the CMOS integrated circuit.

Further, JP-A-58-207671 discloses a semiconductor device having a base diffusion layer on one main surface of a semiconductor substrate and an emitter diffusion region formed in a portion of the surface thereof, in which a thin semiconductor oxide film formed on the base-emitter junction surface and a polycrystalline semiconductor film formed on said thin semiconductor oxide film are used as an emitter diffusion mask and constitute a peripheral portion of the emitter contact.

JP-A-60-38856 discloses a method of manufacturing a semiconductor device in which an insulated gate electrode is formed of a polysilicon layer or a metal silicide, a source and drain diffusion layer is formed by using the gate electrode and a field oxide film as a mask, and the wiring and electrodes for each transistor are formed of a second polysilicon layer formed on an insulation film on the gate electrode. A base diffusion layer as a base region is previously formed at an appropriate position on the substrate. A portion of the insulation film on the base diffusion layer is removed simultaneously with the formation of a contact hole for disposing source and drain electrodes made of polysilicon and, thereafter, a second polysilicon layer is deposited and an emitter diffusion layer is formed by thermal diffusion of impurities doped into the second polysilicon layer.

In each of the semiconductor devices described above, the N-type diffusion layer is formed by implanting ions of a single impurity element belonging to the group V of the periodical table, for example As (arsenic), P (phosphorus), Sb (antimony). Further, a group-V element, for example P or As, is introduced to form the N-type diffusion layer in silicon. However, if the group-V element is present at a high concentration, secondary defects occur in the high concentration region after a heat treatment. For example, in a case of implanting As at a dose of 4E15 $cm^{-2}$ into a silicon substrate and a subsequent annealing, secondary defects occur in the region at the boundary between single crystal Si and amorphous Si (a-C) (original amorphous/crystalline interface) and in a region in which As is present at a concentration higher than 5E20 $cm^{-3}$ upon implantation. Further, As at a high concentration causes accelerated diffusion resulting in an increased As re-distribution. Accordingly, the secondary defects impair the reliability of the semiconductor device and the As re-distribution hinders miniaturization and increase of the integration degree of the semiconductor device. The secondary defects and the re-distribution do also occur with other group-V elements, that is, P and Sb.

Further, for a MISFET in an IC using for example a silicon substrate, a gate insulation film comprising a silicon oxide film is formed by thermally oxidizing the silicon substrate and a gate electrode, for example composed of polycrystalline silicon, is formed on the gate insulation film. However, the boundary between the substrate and the gate insulation film, that between the substrate and the element isolating insulation film or that between the gate insulation film and the gate electrode is not stable rendering the electric characteristics of the MISFET instable during operation of the IC. For instance, there has been a problem of the degradation in the threshold voltage or the current gain. Although the boundary has been stabilized by $H_2$ forming gas sintering, since the Si-H bond is week, degradation in the characteristics of the MISFET has not been reduced completely yet.

Furthermore, TFTs used for liquid crystal television sets or TFTs and high resistance elements used for LSI such as an SRAM use a thin film polycrystalline silicon or amorphous silicon merely doped with impurities of a group-III or V element.

Further, a silicide layer of metal, for example Ti (titanium), Mo (molybdenum), W (tungsten), Ta (tantalum), Pt (platinum) Pd (palladium), Cr (circonium), etc. is used as a portion of the gate electrode or the source and drain regions. However, since the diffusion of group-V impurities (P or As) in the silicide layer is extremly fast, it is impossible to dope the group-V impurities selectively, for example only to the N-type region by heat treatment through the silicide during the manufacture of a CMOS LSI. For instance, in a gate electrode comprising a dual lamination layer of polycrystalline silicon and metal silicide (polycide), group-V element ions (As) selectively implanted into an N-type MISFET region are diffused into the metal silicide by the subsequent heat treatment, reach as far as a P-type MISFET region and cause As doping also into the polycrystalline silicon of the gate electrode in the P-type region, thereby deteriorating the electric characteristics of the P-type MISFET in CMOS LSI.

In this way, secondary defects are formed in a high concentration region in the diffusion layer comprising group-V impurities at high concentration.

Further, the group-V impurities at high concentration cause accelerated diffusion upon an annealing making it difficult to form a shallow junction. Further, since the group-V element causes violent re-distribution in polycrystalline Si, refractory metal and refractory metal silicide, miniaturization for wirings or elements is impossible.

Further, upon forming an N-type diffusion layer by ion implantation, since secondary defects are also present at the boundary between amorphous Si and single crystal Si, the problem occurs that the performance of the element is deteriorated.

An object of the present invention is to provide a semiconductor device comprising at least one shallow N-type diffusion layer free from secondary defects, and a method of manufacturing such a semiconductor device, as well as attaining a high integration degree in a semiconductor device by restricting the re-distribution of group-V atoms in polycrystalline Si refractory metal and refractory metal silicide.

Another object of the present invention is to provide a semiconductor device including an MISFET, in which the boundary between the gate electrode and the gate insulation layer and the boundary between the gate insulation layer and the substrate are stabilized and which does not suffer from any degradation of electric characteristics of the MISFET during the operation of the IC.

As the quality for the image of television sets is improved and the degree of integration in LSI circuits is increased, devices using polycrystalline silicon or amorphous silicon are miniaturized resulting in the following two problems. At first, group-V or III impurities doped into a silicon thin film undergo a great re-distribution to cause short-circuits in a high resistance portion of a high resistance element and a short-circuit between source and drain regions of a TFT. Accordingly, the miniaturization of the device has been difficult. The boundary between the gate insulation film and the silicon thin film of a TFT is not stable due to silicon dangling bonds, which brings about problems in view of the reliability such that the electric characteristics like the ON current or the threshold voltage during operation are deteriorated and the resistivity of a high resistance region fluctuates.

Accordingly, a further object of the present invention is to provide a semiconductor device in which a miniaturized and highly reliable thin film polycrystalline silicon or amorphous silicon is formed.

A still further object of the present invention is to overcome the foregoing drawbacks of the prior art and to provide a semiconductor device of such a structure in which the diffusion of group-V impurities in refractory metal silicide is surpressed and disadvantages in CMISLSI caused by the re-distribution of group-V elements through the refractory metal silicide is avoided.

These objects are achieved with a semiconductor device and a method for manufacturing it, respectively, as claimed.

The present invention further provides a method of manufacturing a semiconductor device in which the profile of introduced impurities of the high electronegativity or the halogen element impurities is distributed more deeply than the amorphous layer formed upon introducing ions of the group-V impurity.

It is considered in the present invention that, since the elements of the group-V impurity (Sb, As, P, etc) and the impurity element of high electronegativity or of a halogen element impurity (F, O, Cl, Br, S, I, N) form covalent bonds or ionic bonds, etc. in amorphous, polycrystalline or single crystalline silicon, refractory metal or silicide of such metal to avoid trapping of interstitial silicon with the group-V impurities, accelerated diffusion caused by the interstitial silicon or interstitial silicon type secondary defects are suppressed.

Further, since the diffusion of an element such as F, O, Cl, Br, S, I or N is faster than that of a group-V element, these atoms can be present at stable positions, i.e. only inside of the profile of the group-V element by annealing. Further, the re-distribution of the group-V element in wirings can be suppressed by incorporating the impurities of high electronegativity in polycrystalline Si, refractory metal or silicide of refractory metal.

One effect of the present invention results from the fact that atoms of the impurity element of high electronegativity or halogen impurity element are present at the boundary between the gate insulation film and the substrate or at the boundary between the gate electrode and the gate insulation film. Since for instance F forms a strong bond with Si, there are no dangling bonds at the boundary between $SiO_2$ and Si resulting in a stable boundary.

The effects of the present invention are further contributable to the fact that the re-distribution of the group-V element in a refractory metal silicide is suppressed by incorporating an impurity of a high electronegativity, for example F, O, Cl, Br, S, I, N in the refractory metal silicide. Although the mechanism has not yet been apparent at present, it is considered that for instance diffusion of As in $TiSi_2$ causes a re-distribution by way of the dangling bonds of silicon present at the grain boundary of $TiSi_2$. On the other hand, if F having a high electronegativity, for example, is incorporated into $TiSi_2$, since the silicon dangling bonds at the grain boundary have a large Si-F bon ding energy, they bond with F to eliminate the As diffusion activity to suppress the As re-distribution.

These and other objects and advantages of the present invention will become apparent from the following description of preferred embodiments of the present invention in conjunction with the accompanying drawings, wherein:

Fig. 1 is a longitudinal cross-sectional view illustrating a basic structure of a bipolar element according to the present invention,

Figs.2(a) - (i) are cross-sectional views illustrating the steps in Example 1 of a method of manufacturing a bipolar MISIC according to the present invention,

Figs.3(a) - (c) are cross-sectional views illustrating the steps in Example 2 of a method of manufacturing a semiconductor device according to the present invention,

Fig. 4 is a cross-sectional view illustrating a principal portion in Example 3 of a structure of a semiconductor device according to the present invention,

Figs.5 and 6 are cross-sectional views illustrating principal portions in Example 4 of a structure of a semiconductor device according to the present invention,

Fig. 7 is a cross-sectional view illustrating a principal portion in Example 5 of a structure of a semiconductor device according to the present invention,

Figs.8(a) and (b) are photographic views illustrating the state of crystals upon introducing As impurities in an example corresponding to the present invention and another one corresponding to the prior art, respectively,

Fig. 9 is a graph illustrating the relationship between the concentration and the depth of As impurities in an example according to the present invention and one according to the prior art,

Figs.10(a) and (b) are photographic views illustrating the state of crystals upon introducing P impurities in an example according to the present invention and one according to the prior art, respectively, and

Fig. 11 is a graph illustrating the relationship between the concentration and the depth of P impurities in the example according to the present invention and that according to the prior art.

Example 1

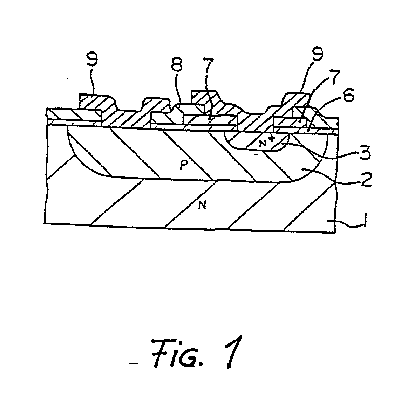

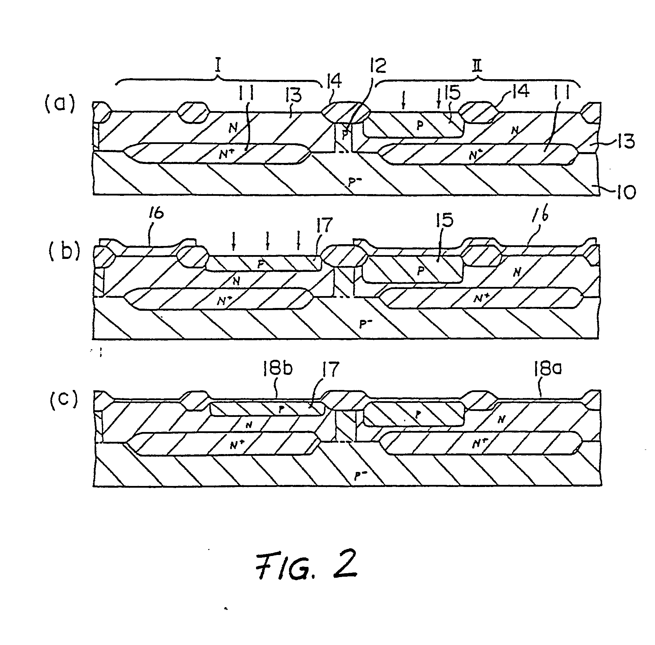

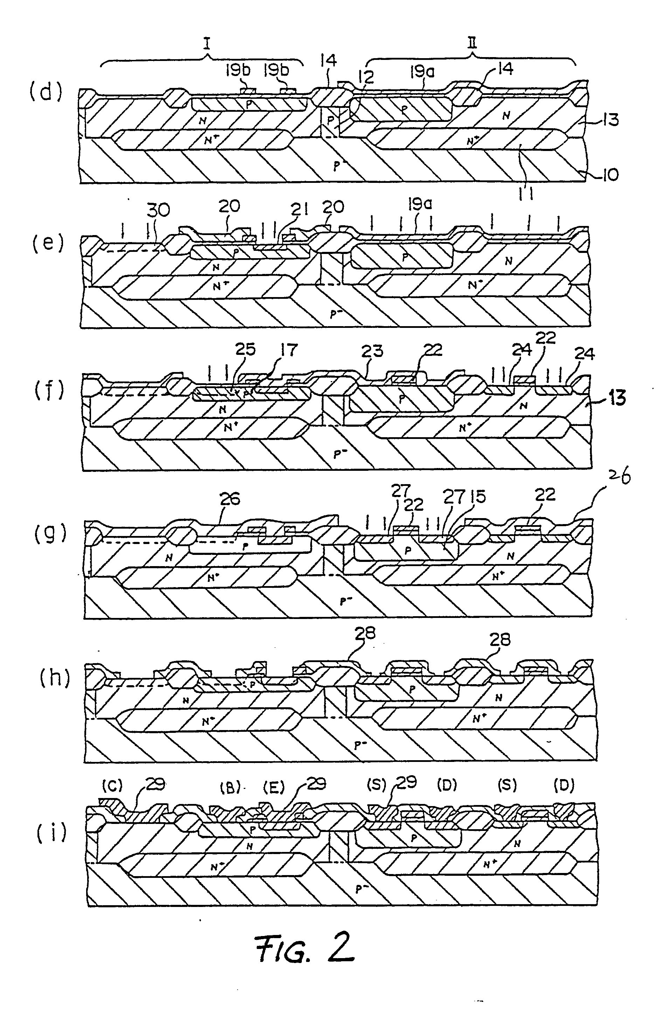

Fig. 1 is a cross-sectional view of a basic structure of a bipolar device according to the present invention and Figs. 2(a) - (i) are cross-sectional views illustrating the steps of the process for manufacturing a bipolar CMISIC device according to the present invention.

Shown in the drawings are an N-type semiconductor substrate 1 forming a collector of the bipolar device, a P-type diffusion layer 2 forming a base, an $N^+$-type diffusion region 3 forming an emitter, a thin oxide film 6, a polycrystalline semiconductor film (polysilicon film) 7, a PSG film (phosphorus silicate glass film) 8, an Al electrode 9 for ming base and emitter electrodes, a $P^-$-type silicon substrate 10, an $N^+$-type embedded layer 11, an isolation P-type layer 12, an N-type epitaxial layer 13, an element isolation oxide film 14, a P-type well 15, a mask 16, a base region 17, thin oxide films 18a, 18b, polysilicon films 19a, 19b, a mask 20, an $N^+$-type emitter 21, a polysilicon gate 22, a mask 23, $P^+$-type source and drain 24, a $P^+$-type base contact 25, a mask 26, $N^+$-type source and drain regions 27, a PSG film 28, an Al electrode (wiring) 29, and an $N^+$-type collector contact portion 30.

The $N^+$-type diffusion region 3 shown in Fig. 1 is constituted by forming an $N^+$-type diffusion layer comprising a group-V impurity element such as As or P and an impurity of high electronegativity, for example F, Cl, O, Br, S, I or N.

The steps for manufacturing a semiconductor device according to the present invention will now be explained orderly in accordance with Figs. 2(a) - (i).

(a) At first, the $N^+$-type layer 11 is embedded on one main surface of the $P^-$-type silicon substrate (wafer) 10. N-type epitaxial layers 13 isolated from each other by the isolation P-type layer 12 and the element isolating insulation film 14 are epitaxially grown. They have a sheet resistivity of about 1 $\Omega$/$\square$ and a thickness from 3 to 10 $\mu$m.

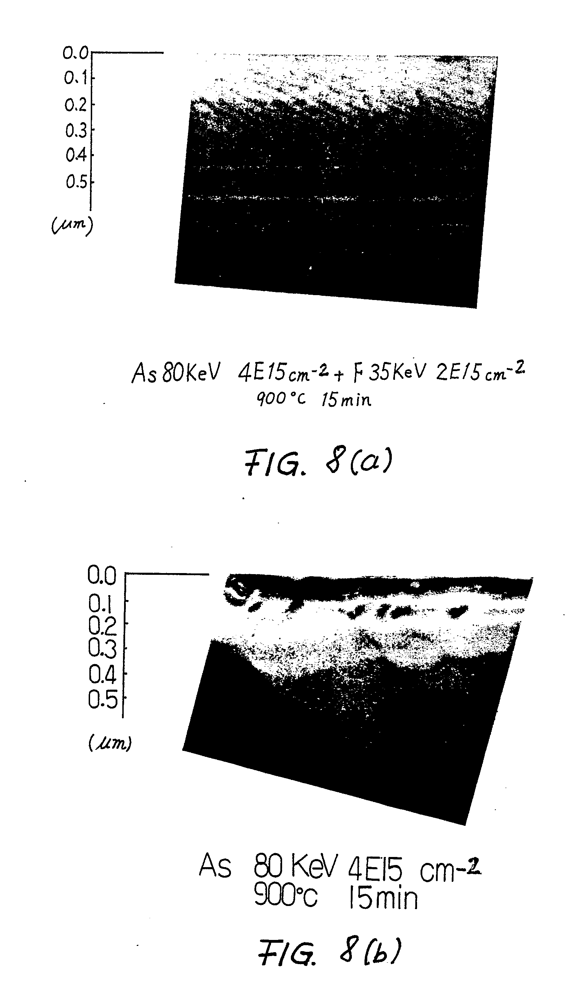

In this case, if the $N^+$-type layer 11 includes a group-V impurity element and an impurity element of high electronegativity or a halogen impurity element such as As and F, Sb and F, etc., a satisfactory substrate can be obtained with no defects in the epitaxially grown silicon layer 13 and with no re-distribution in the $N^+$-type embedded layer 11. Figs. 8(a) and (b) show the result of a TEM observation of the cross-section of a sample (b) prepared by implanting As at a dose of 4E 15 $cm^{-2}$ at 80 keV and a sample (a) prepared by additionally implanting F at 35 keV to a dose of 2E 15 $cm^{-2}$ after implanting As to a dose of 4E 15 $cm^{-2}$ and 80 keV, and after the samples had been annealed in an $N_2$ atmosphere at 900°C for 15 min. Fig. 8(a) shows the embodiment according to the present invention (sample (a)) and Fig. 8(b) shows a conventional embodiment (sample (b)). Secondary defects were observed in sample (b) including only As, whereas no secondary defects occurred in the sample (a) where F was additionally implanted. The $N^+$-type embedded layer 11 can also be formed by ion implantation at high energy, for example an MeV ion implantation of As or P. In this case, if an element of high electronegativity (for example F) is MeV ion implanted together with group-V ions, a diffusion layer 11 with less re-distribution and restricted defects can be obtained.

The element isolation oxide layer 14 is then formed by selectively oxidizing the surface of the N-type epitaxial Si layer 13 at low temperature, which is further isolated into smaller regions (Fig. 2(a)).

In Fig. 2, I represents a region in which a bipolar element is formed and II represents a region in which an MIS element is formed.

The P-type well 15 is formed by a selective ion implantation of B (boron) impurities to a depth of about 4 $\mu$m in a portion isolated by the element isolation oxide layer 14 in region II.

(b) A mask 16 is formed by photoresist processing, and the P-type base region 17 is formed to a depth of 1.5 $\mu$m by a deposition diffusion of B at the surface of the N-type layer 13 in a portion of region I (Fig. 2(b)).

(c) After removing the mask material at the surface and the surface oxide film, gate oxidation is carried out to form thin thermally oxidized films 18a and 18b over the entire surface. In this case, the oxide film 18a of a thickness of 10 nm to 100 nm is formed in region II as the gate insulation film, whereas the oxide film 18b in region I is formed to a thickness greater than that of film 18a, for example 11 nm to 130 nm by accelerated oxidation with B at the surface of the base region 17 (Fig. 2(c)).

(d) On the entire surface silicon is then deposited from the gas phase to form polysilicon films 19a and 19b. The polysilicon film 19b in region I is then selectively removed by photoresist processing, leaving the polysilicon film 19b only in the peripheral portion of the emitter (Fig. 2(d)).

(e) After ion implantation of impurities such as As to a dose of 4E 15 $cm^{-2}$ using the mask 20 formed by a photoresist processing on the surface of the base region 17 except for the emitter portion 21, an element of high electronegativity, that is, F, Cl, O, Br, S, I or N, for example F, is ion implanted at a concentration of 2E 15 $cm^{-3}$ and diffused, followed by annealing at 900°C for 15 min to form the $N^+$-type emitter region 21 and the $N^+$-type collector contact portion 30.

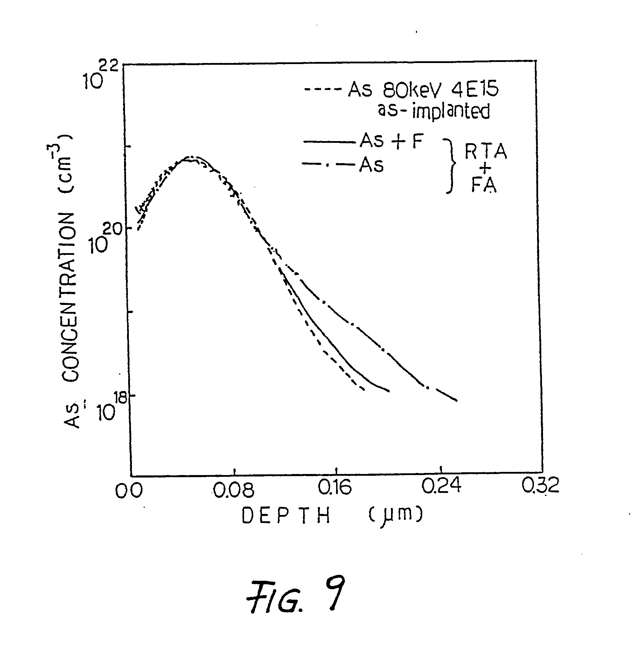

By setting the As implantation energy to 80 keV and the F implantation energy to 35 keV, the F distribution upon the implantation extends to a region deeper than the a - c (original amorphous/crystalline) boundary upon implantation. No secondary defects are present in the As implantation layer according to this embodiment as shown in Fig. 8(a) Further As re-distribution can also be restricted as shown in Fig. 9.

In Fig. 9, the As profile in the case of applying rapid thermal annealing (RTA) at 1020°C and, thereafter, furnace annealing (FA) at 650°C is compared between a sample prepared by implanting only As at 80 keV and a concentration of 4E 15 $cm^{-3}$ and a sample with As and·F implantation according to this embodiment. The sample with the additional F implantation according to this embodiment exhibits a shallow junction with less As re-distribution.

Further, after a heat treatment at 900°C for 15 min, F is distributed only to the inside of the As profile.

At the same time, N-type impurities are diffused at a high concentration into the polysilicon film 19a in the MIS region II to lower the resistance. Further, in a case of selectively forming a polycrystalline silicon wiring layer having a high resistivity, which is effective in the high resistance wiring layer used for an SRAM, etc., if As and F are implanted into the diffusion layer region of the polycrystalline silicon, As can be suppressed from diffusing in the polycrystalline silicon in the lateral direction, thereby enabling a miniaturization of the high resistance wiring. Further, in a case where films 19a and 19b comprise a gate electrode containing a silicide of a refractory metal, for example a polycide structure, the lateral re-distribution of a group-V impurity in the polycide wiring layer is restricted by the presence of the impurity of high electronegativity in this embodiment. Accordingly, there is no disadvantage due to a re-distribution of the group-V element in the silicide (Fig. 2(e)).

The deposition of the N-type impurity may be applied just after the formation of the polysilicon film in step (d).

(f) Gate photoetching is applied to the polysilicon film 19a in region II to expose the surface of the semiconductor in the source and drain portions and, at the same time, form the polysilicon gates 22.

Then B (boron) is deposited or ion implanted or diffused after a portion of the surface has been covered by mask 23, to form the $P^+$-type regions 24 as source and drain to a depth of 0.1 to 0.8 $\mu$m self-aligned with the gate at the surface of the N-type layer 13 in region II.

On the other hand, on the bipolar side in region I, the $P^+$-type layer 25 with high concentration for the base contact is formed in the surface of base region 17.

(g) Only the portion above the P-type well 15 on the MIS side (region II) is exposed while other portions are covered with the mask 26, and then As is ion implanted in the same manner as in step (e). Then F is implanted and diffused by annealing, thereby forming the $N^+$-type regions 27 as source and drain self-aligned with the gate to a depth of 0.05 to 0.8 $\mu$m at the surface of the P-type well 15.

In this case, if both, P and F are implanted, a shallow junction with less secondary defects and less re-distribution can be formed.

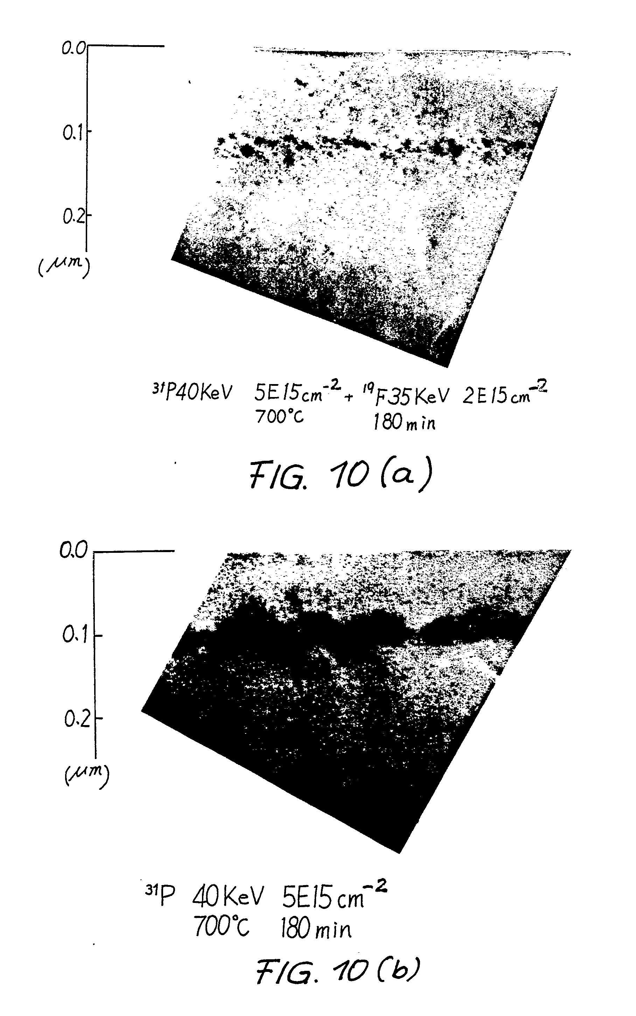

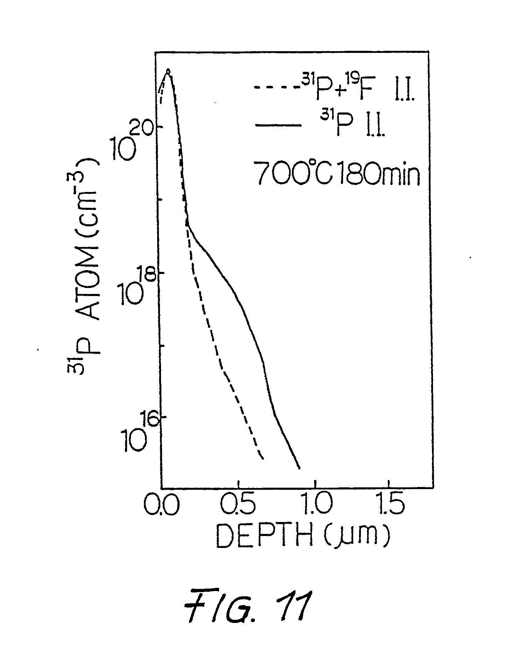

Figs. 10(a) and (b) and Fig. 11 show the cross-sectional TEM images and the P profile, respectively, after annealing in an $N_2$ atmosphere at 700 °C for 180 min of a sample (b) prepared by implanting $^{31}P$ at 40 keV and a concentration of 5E 15 $cm^{-3}$ and a sample (a) prepared by implanting $^{31}P$ at 40 keV and a concentration of 5E 15 $cm^{-3}$ and, thereafter, implanting $^{19}F$ at 35 keV and a concentration of 2E 15 $cm^{-3}$. In sample (a) according to this embodiment, the growing of secondary defects is suppressed and the P-distribution of the P tail is small. Relative to this, in sample (b), growing of secondary defects is found. Accordingly, in sample (a) a shallow junction with restricted defects is formed (Fig. 2(g)).

(h) After depositing the PSG film 28 over the entire surface, contact photoetching is carried out (Fig. 2(h)).

(i) Al is vapor deposited (or sputtered) and pattern-etched to form the electrode (wiring) 29 in ohmic contact with each of the regions (Fig. 2(i)).

By the process described above a Bi-CMISIC including an NPN transistor having an emitter of fine size and a short channel MISFET is completed.

Although the above explanation has been made for a case where the present invention is applied to a Bi-CMISIC including an NPN transistor and a short channel MISFET, the present invention is not restricted to only this example but is applicable to any semiconductor device as long as it comprises an N-type diffusion layer or a wiring layer of polycrystalline silicon, metal or metal silicide, containing a group-V element.

Silicon is not restricted only to polysilicon and single crystal silicon, but may also be amorphous silicon. Further, the characteristics shown in Figs. 8 through 11 are similar in the other examples 2 - 5 explained later.

In the present example, the group-V impurity is introduced at a high concentration and an energy of 40 keV and 80 keV. However, when the concentration is low, the same effects as in this example can be obtained by increasing the implantation energy to more than 100 keV, thereby increasing the interstitial silicon.

In conventional semiconductor devices, a diffusion layer comprising a group-V impurity at a high concentration is formed upon forming an N-type diffusion layer by implanting ions of a single group-V element, for example As or P. However, since there is a great re-distribution of the group-V element impurity due to an accelerated diffusion, it has been difficult to form a shallow junction. Further, the redistribution of the group-V element is also great in the wiring of polycrystalline silicon and polycide and it has, thus, been difficult to reduce the size of the wiring.

Further, in a case where the secondary defects are formed in the high concentration region the secondary defects are also present at the original boundary region between the amorphous silicon and the single crystal silicon upon implantation when the N-type diffusion layer is formed by ion implantation, which leads to the problem that the device performance is reduced. However, the present invention enables to provide a semiconductor device comprising an N-type diffusion layer free from secondary defects and having a shallow junction. Further, since the re-distribution of the group-V impurity is suppressed in the polycrystalline silicon, metal and silicide wiring in this example, the invention enhances the miniaturization and high integration degree for the high resistivity polycrystalline silicon device or polycide gate electrode shown in other examples.

## Example 2

In this example As, which has most generally been used for N-type diffusion layers, is used as the group-V element, but the situation will be similar with P or Sb from the theoretical point of view. Further, although in this example the explanation will be made on the basis of F having the highest electronegativity, similar effects can be obtained with other elements of high electronegativity such as Cl, O, N, Br, I or S although the degree of the effect is somewhat reduced.

After implanting As at a high concentration to a silicon (100) substrate, F is implanted at such an energy as to substantially overlap the As implantation profile. F may by implanted before the As implantation.

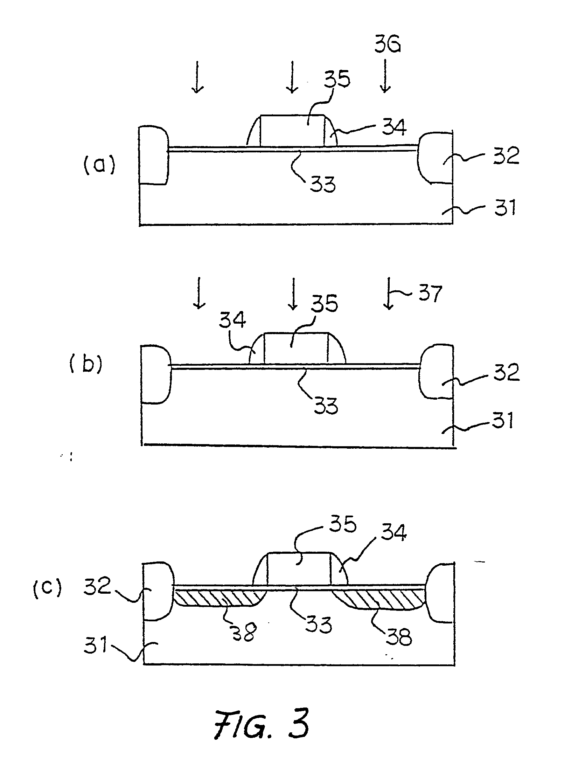

Figs. 3(a) - (c) are cross-sectional views showing different steps of a process for forming the source and drain regions of a MISFET. Shown in Fig. 3(c) on a silicon substrate 31 is a MISFET comprising a gate electrode 35, a gate insulation film 33, a side wall insulation film 34 and source and drain regions 38 isolated by an element isolating insulation film 32 such as $SiO_2$. As shown in Fig. 3(a), As 36 is selectively implanted at a high dose energy (for example 80 keV, 4E 15 $cm^{-2}$) in the source and drain regions 38. Then, after selectively implanting F 37 (for example at 35 keV, 2E 15 $cm^{-2}$) in the same regions, a heat treatment is applied (for example at 900°C for 15 min in an $N_2$ atmosphere) as shown in Fig. 3(b). Thus, the source and drain regions 38 are formed. Accordingly, Fig. 3(c) shows a MISFET having an N-type diffusion layer comprising two kinds of impurities, namely As and F at high concentration in the source and drain regions 38.

In the manufacturing method according to the present invention, since F can restrict the accelerated diffusion of As at high concentration, and the occurrence of secondary defects, the N-type diffusion layer 38 can be obtained free from secondary defects and with less As re-distribution. Accordingly, a miniaturization of the MISFET is possible to provide an LSI semi-conductor device of a high reliability and a high integration degree.

Example 3

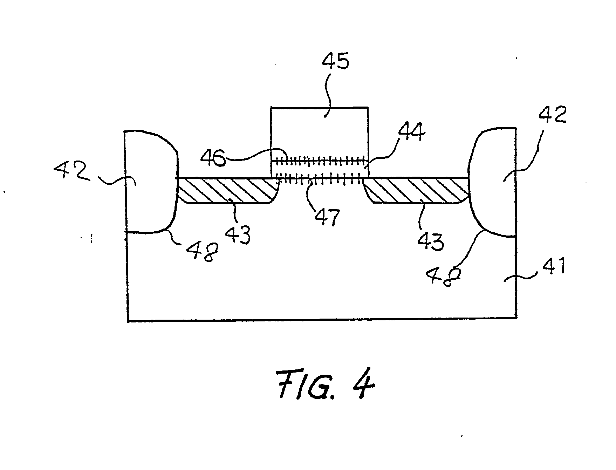

Fig. 4 shows a cross-sectional view of another example of the semiconductor device according to the present invention. An MISFET isolated by an element isolating insulation film 42 is formed on a silicon substrate 41. The MISFET comprises source and drain regions 43, a gate insulation film 44 and a gate electrode 45. F atoms are present near the boundary 47 between the gate insulation film 44 and the silicon substrate 41 or the interface 48 between the element isolating insulation film 42 and the silicon substrate 41. This can be attained by annealing in an F-containing atmosphere or implanting F-containing ions after forming the gate insulation film 44. F atoms are present also near the boundary 46 between the gate electrode 45 and the gate insulation film 44. The F atoms are particularly effective when the gate electrode is made of polycide or polysilicon. F in the region of boundary 46 can be introduced by annealing in an F-containing atmosphere or by implanting F-containing ions after forming the gate electrode 45. Further, when F is introduced after forming the gate electrode 45 and applying a high temperature annealing to the source and drain regions 43, Si-F bonds are stable in a heat treatment of a subsequent step.

Further, F can also be introduced into the boundary 46, 47 or 48 by implanting the F atoms, for example, by an MeV ion implantation after forming a wiring layer for connecting the MISFET.

Instead of the F atoms, impurities of high electronegativity like that of the F atoms or halogen atom impurities, for example Cl, O, Br, S, I or N can be used in the same manner.

According to the present invention, since the F atoms are present at the boundaries as mentioned above, these boundaries are stable due to strong Si-F bonds and free from dangling bonds. Accordingly, the electric characteristics of the MISFET do not change during the operation of an IC and a semiconductor device of a high reliability can be provided.

Example 4

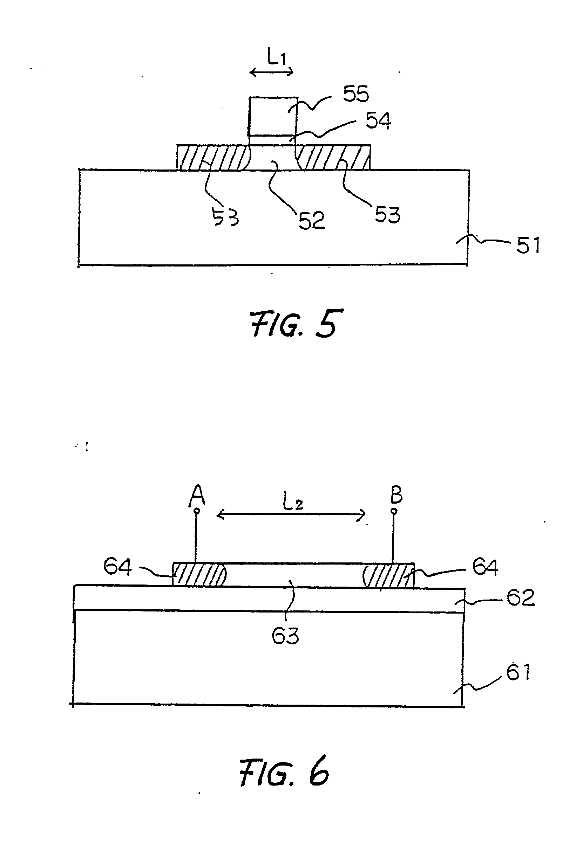

Fig. 5 is a cross-sectional view of a TFT forming another example of the present invention. The figure shows an MISFET comprising a glass or quartz substrate 51 and an amorphous silicon or polycrystalline silicon thin film 52 formed thereon, and having a gate electrode 55, a gate insulation film 54 and source and drain regions 53. F atoms are contained in the amorphous silicon or polycrystalline silicon film 52 in the source and drain regions 53 or the channel region by means of F ion implantation or annealing in an F-containing atmosphere. As has been described above, since the F atoms restrict the re-distribution of impurities, for example P or As in the source and drain regions 53, no short-circuit is caused even if the channel length $L_1$ is reduced. Further, F also stabilizes the boundary bet ween the gate insulation film 54 and the silicon thin film 52.

Fig. 6 is a cross-sectional view of a high resistance silicon element used in an SRAM according to this example. An interlayer insulation film 62 is formed on a silicon substrate 61 and a polycrystalline silicon thin film 63 is formed on the interlayer insulation film 62. The polycrystalline silicon thin film 63 is connected with wirings A and B through impurity doped regions 64 including group-V (P, As, etc.) or group-III (B, etc.) dopants. The resistivity is determined by the intermediate region not doped with the impurity, that is by the length $L_2$. In this example, F atoms are contained in the high resistance region 63 or the impurity doped regions 64 by F ion implantation or annealing in an F-containing atmosphere. Heretofore, if the length $L_2$ was reduced to less than 2 $\mu$m, a short-circuit occurred due to the re-distribution of the P, As or B, etc. impurity upon heat treatment in a subsequent step. That is, the impurity is diffused also into a region which was intended to be a resistor but which does no longer function as such. However, the re-distribution of the impurity such as B or P, As, etc. is restricted by the introduction of F and no short-circuit is caused even if the length $L_2$ is reduced into the sub-micron order, thereby enabling to obtain a stable high resistance region.

Instead of the F atoms, impurities of high electronegativity like that of the F atoms or a halogen element impurity, for example Cl, 0, Br, S, I or N can be used in the same manner.

As has been described above, according to this example, it is possible to prepare a TFT element or a high resistance element comprising a thin film of polycrystalline or amor phous silicon of sub-micron order and a miniaturized and highly reliable semiconductor device can be provided.

Example 5

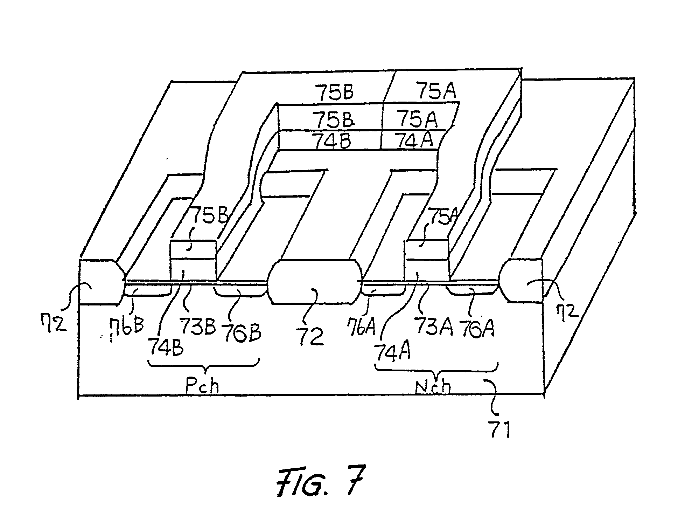

Fig. 7 is a cross-sectional view of a CMISFET semiconductor device forming another example of the present invention. On a silicon substrate 71, a P-type MISFET (P-channel transistor) and an N-type MISFET (N-channel transistor) are formed being isolated by an element isolating insulation film 72 made of $SiO_2$ etc. Then, respective FETs are connected with polycide gate electrodes composed of polycrystalline silicon (74A, 74B) and $TiSi_2$ (75A, 75B). The N-type MISFET comprises a gate insulation film 73A, polycide electrodes (74A, 75A) and source and drain regions 76A. The P-type MISFET comprises a gate insulation film 73B, polycide electrodes (74B, 75B) and source and drain regions 76B. The gate electrodes 74A and 75A of the N-type MISFET contain a group-V element, for example P or As at a high concentration. On the other hand, the P-type MISFET contains a group-III element, for example B in the gate electrodes 74B and 75B. Heretofore, P or As contained in gate electrodes 74A, 75A is diffused in a subsequent heat treatment to the TiSi: gate portion 75B and, further, discharged to the polycrystalline silicon 74B. By that the threshold voltage of the P-type MISFET has been shifted and the electrical characteristics have not been stabilized. On the other hand, in this example, since F is implanted into the $TiSi_2$ gate portion 75A, a re-distribution of P or As in gate portions 74A and 75A is restricted and no diffusion into gate portion 75B occurs, so that P or As is not present in gate portion 74B or 75B. Accordingly, the electrode of the P-type MISFET is constituted with polycrystalline silicon 74B at a predetermined carrier concentration, and the P-type MISFET has electrical characteristics with less fluctuation.

The situation is similar also for other refractory metal silicides, for example, silicides of Mo, W, Ta, Pt, Pd or Zr may also be used.

Further, the situation is similar for refractory metal per se instead of high melting metal silicide. In addition, an impurity element of high electronegativity such as Cl, O, Br, S, I and N instead of F can also be used to obtain similar effects although at a different extent.

As has been described above according to this example, the re-distribution of the group-V impurity in the high melting metal silicide is restricted, thereby enabling to obtain a semiconductor device capable of avoiding the disadvantage in CMILSI caused by the re-distribution of the group-V element.

In examples 1 to 5 above, among the impurities of high electronegativity or halogen impurity elements, F particularly has a remarkable effect as compared with that of Cl, O, Br, S, I or N.

In conventional semiconductor devices, an N-type diffusion layer comprising a group-V impurity at high concentration has been formed by implanting ions of a single group-V impurity element, for example As, P, etc. However, the redistribution of the group-V impurity element due to accelerated diffusion is remarkable, making it difficult to form a shallow junction. In addition, the re-distribution of the group-V impurity element is also remarkable in the wiring of polycrystalline silicon or polycide, making it difficult to miniaturize the wiring.

Further, since secondary defects are formed in the high concentration region and the secondary defects are present in the boundary region between amorphous state and single crystal state silicon upon implantation in addition to the high concentration region when the N-type diffusion layer is formed by ion implantation, there has been the problem that the element performance is reduced. However, in the semiconductor device according to the present invention it is possible to provide a semiconductor device having an N-type diffusion layer free from secondary defects and having a shallow junction. Further, in the present invention, since the re-distribution of the group-V impurity is restricted in the wiring of polycrystalline silicon, metal and silicide, miniaturization and the integration degree can be enhanced for high resistance polycrystalline silicon elements, TFT devices or polycide gate electrodes.

**Claims**

1. A semiconductor device having at least one region which contains a first impurity comprising a group-V element and a second impurity comprising an element of high electronegativity or an halogen element, in amorphous silicon, polycrystalline silicon, single crystalline silicon, refractory metal such as Ti, Mo, W, Ta Pt, Pd and Zr or a silicide of such refractory metal.

2. A semiconductor device as defined in claim 1, wherein the second impurity is F.

3. A semiconductor device as claimed in claim 1, wherein the second impurity is Cl, O, Br, S, I or N.

4. A semiconductor device as defined in any of the preceding claims, wherein the first impurity comprises P, As or Sb alone or in combination.

5. A semiconductor device as defined in any of the preceding claims, wherein the profile of the second impurity is shallower than the profile of the first impurity and the concentration of the second impurity is lower than that of the first impurity.

6. A semiconductor device as defined in any of the preceding claims, wherein the peak concentration of the first impurity exceeds $1E\ 20\ cm^{-3}$.

7. A method of manufacturing a semiconductor device which comprises the step of introducing a second impurity comprising an element of high electronegativity or an halogen element before, after or during the introduction of the first impurity comprising a group-V element into amorphous silicon, polycrystalline silicon, single crystal silicon, refractory metal such as Ti, Mo, W, Ta, Pt, Pd or Zr or a silicide of such refractory metal, and a step of annealing in order to form an N-type impurity region.

8. The method as defined in claim 7, wherein the second impurity is F.

9. The method as defined in claim 7, wherein the second impurity is Cl, O, Br, S, I or N.

10. The method as defined in any of claims 7 to 8, wherein the first impurity is P, As or Sb alone or in combination.

11. The method as defined in any of claims 7 to 10, wherein the profile of the second impurity is shallower than that of the first impurity and the concentration of the second impurity is lower than that of the first impurity.

12. The method as defined in any of claims 7 to 11, wherein the peak concentration of the first impurity exceeds $1E\ 20\ cm^{-3}$.

13. The method as defined in any of claims 7 to 12, wherein the profile of the second impurity upon introduction is distributed more deeply than the amorphous region formed upon introduction of the first impurity.

14. A semiconductor device in which a gate insulation film (44) disposed on a semiconductor substrate (41) comprises a silicon nitride film or silicon oxide film, wherein a first impurity comprising an element of high electro negativity or an halogen element is present in a first region (47) near the boundary between said gate insulation film (44) and said semiconductor substrate (41) and in a second region (46) near the boundary between said gate insulation film (44) and a gate electrode (45) disposed thereover.

15. The semiconductor device as defined in claim 14, wherein the first impurity is present in a third region (48) near the boundary between an element isolating insulation film (42) and said semiconductor substrate (41).

16. A semiconductor device having an element comprising a silicon thin film (52; 63) such as a polycrystalline or amorphous silicon thin film doped with a first impurity comprising an element of high electronegativity or halogen element, on an insulation substrate (51) or insulation film (62).

17. The semiconductor device as defined in claim 16, wherein the element is a high resistance element comprising a region (64) of the silicon thin film (63) doped with a group-III or V impurity, and a high resistance region.

18. The semiconductor device as defined in claim 16, wherein the element is a thin film transistor having source and drain regions (53) and a channel region in the silicon thin film (52).

19. A semiconductor device comprising a silicide layer (74a, 75a, 74b, 75b) of a refractory metal such as Ti, Mo, W, Ta, Pt, Pd or Zr containing a first impurity comprising an element of high electronegativity or a halogen element, in at least a portion of a region for each of a source and drain region or gate electrode of an N-type MISFET in a complementary type MIS semiconductor device.

20. The semiconductor device as defined in any of claims 14 to 19, wherein the first impurity is F.

21. The semiconductor device as defined in any of claims 14 to 19, wherein the first impurity is Cl, O, Br, S, I or N.

89/87129 EP

_FiG. 1

FIG. 2

EP 0 350 845 A2

FIG. 2

FIG. 3

FIG. 4

$L_1$

55

54

53          52          53

51

FIG. 5

A          $L_2$          B

64                          64

62

63

61

FIG. 6

*FIG. 7*

As 80KeV  4E15 cm⁻² + F 35KeV  2E15 cm⁻²
900°C  15 min

**FIG. 8(a)**

As  80 KeV  4E15 cm⁻²
900°C   15min

**FIG. 8(b)**

FIG. 9

$^{31}P\,40\,KeV$  $5E15\,cm^{-2}$ + $^{19}F\,35\,KeV$  $2E15\,cm^{-2}$
700°C  180 min

## FIG. 10 (a)

$^{31}P$  $40\,KeV$  $5E15\,cm^{-2}$
700°C  180 min

## FIG. 10 (b)

FIG. 11